(19) Europäisches Patentamt
European Patent Office
Office européen des brevets

(11) Veröffentlichungsnummer: **0 166 682 B1**

(12) **EUROPÄISCHE PATENTSCHRIFT**

(45) Veröffentlichungstag der Patentschrift: **08.01.92**

(51) Int. Cl.5: **G03F 7/004**

(21) Anmeldenummer: **85810233.8**

(22) Anmeldetag: **15.05.85**

(54) **Verfahren zur positiven Bilderzeugung.**

(30) Priorität: **25.05.84 GB 8413395**

(43) Veröffentlichungstag der Anmeldung:
**02.01.86 Patentblatt 86/01**

(45) Bekanntmachung des Hinweises auf die Patenterteilung:
**08.01.92 Patentblatt 92/02**

(84) Benannte Vertragsstaaten:
**BE CH DE FR GB IT LI NL SE**

(56) Entgegenhaltungen:
**EP-A- 0 058 638** **EP-A- 0 084 515**
**EP-A- 0 089 922** **GB-A- 2 120 263**
**US-A- 4 258 121** **US-A- 4 371 605**

**PATENTS ABSTRACTS OF JAPAN, Band 7, Nr. 220 (P-226)[1365], 30. September 1983; & JP-A-58 114 030 (FUJITSU K.K.) 07-07-1983**

(73) Patentinhaber: **CIBA-GEIGY AG**
**Klybeckstrasse 141**
**CH-4002 Basel(CH)**

(72) Erfinder: **Demmer, Christopher George, Dr.**
**20 Wolsey Way**
**Cherry Hinton Cambridge CB1 3JQ(GB)**
Erfinder: **Irving, Edward, Dr.**
**41, Swaffham Road**
**Burwell Cambridge CB5 0AN(GB)**

**EP 0 166 682 B1**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

**Beschreibung**

Die Erfindung betrifft ein Verfahren zur Bilderzeugung unter Verwendung eines positiven Photolacks, die in diesem Verfahren einsetzbaren lichtempfindlichen Stoffgemische und Trägermaterialien, die mit einem solchen Stoffgemisch oder einem nach dem erfindungsgemässen Verfahren erzeugten Bild versehen sind.

Bei der Bilderzeugung mittels positiver Photolacke werden die aktinischer Bestrahlung ausgesetzten Stellen des Lacks in einem Entwickler löslicher oder mindestens leichter entfernbar als die nicht bestrahlten Stellen. Beim Entfernen der belichteten Stellen mit dem Entwickler, der die nicht belichteten Stellen intakt lässt, entsteht ein positives Bild.

Im Handel erhältliche positive Photolack-Zusammensetzungen enthalten im allgemeinen neben einem filmbildenden organischen Material ein o-Naphthochinondiazid, das sich bei der Bestrahlung mit aktinischem Licht unter Freisetzung von Stickstoff und unter Bildung einer Idencarbonsäure zersetzt. Das filmbildende organische Material ist im allgemeinen ein alkali-löslich Phenol-Formaldehyd-Novolakharz. Dessen Lösung in wässriger alkalischer Lösung wird durch das Naphthochinondiazid gehemmt; wenn sich jedoch das Diazid in den mit aktinischem Licht bestrahlten Bereichen zersetzt, vermindert sich dessen Wirksamkeit als die Lösung hemmendes Mittel, und die belichteten Stellen der Beschichtung werden in basischen Entwicklern löslicher als die nicht belichteten Stellen. Chinondiazide sind wegen ihrer thermischen Unbeständigkeit nicht ganz zufriedenstellend. Selbst unter Schutz gegen aktinische Strahlung zersetzten sie sich bei mässig erhöhten Temperaturen, und es werden dabei Bilder mit geringerer Qualität erhalten. Ausserdem werden relativ hohe Mengen dieser Diazide als lösungshemmende Mittel benötigt. Da sie in dem bevorzugten tiefen UV-Bereich stark absorbieren, sind solche Diazide enthaltende Stoffgemische gegenüber Strahlung in diesem Bereich relativ opak und können nicht in die Tiefe, z.B. bis zur Oberfläche des Trägermaterials entwickelt werden, weil die Strahlung nicht tief genug in die Beschichtung eindringt.

Es wurde nun gefunden, dass die Löslichkeit von ein filmbildendes organisches Material und eine unter Bestrahlung eine Sulfonsäure abgebende Substanz enthaltendem Stoffgemischen in wässrigen basischen Entwicklern durch Bestrahlen mit aktinischem Licht an den belichteten Stellen erhöht werden kann.

Substanzen, die unter der Einwirkung von aktinischem Licht Sulfonsäuren freigeben, sind bekannt. Sie wurden bisher zum Härten von säure-härtbaren Substanzen, wie Aminoplasten und Phenol-Aldehyd-Resolen, oder bei der Photopolymerisation von Substanzen mit ethylenisch ungesättigten Gruppen als freie Radikale bildende Verbindungen eingesetzt. Bisher war es nicht bekannt, dass Verbindungen, die als latente Sulfonsäurequellen wirken, die Lösungsgeschwindigkeit von bestimmten filmbildenden Materialien in wässrigem basischem Medium herabsetzen können, und dass sich diese Wirkung durch Freisetzung von Sulfonsäuren aufheben lässt.

Weiter beschreibt die JP-OS 58-114030 ein Verfahren zur Erzeugung von positiven Bildern, wobei ein strahlungsempfindliches Gemisch enthaltend ein filmbildendes Material und eine strahlungsempfindliche Verbindung eingesetzt wird, die bei der Bestrahlung mit energiereicher Strahlung u.a. eine Sulfonsäure freigibt und nach der Bestrahlung die bestrahlten Stellen mit einem alkalischen Entwickler entfernt werden.

Gegenstand der Erfindung ist somit ein Verfahren zur Bilderzeugung, indem man

(i) ein auf einem Trägermaterial befindliches Stoffgemisch, das

(A) ein filmbildendes organisches Material und

(B) einen Sulfonsäureester eines aromatischen Alkohols mit einer Carbonylgruppe oder ein aromatisches N-Sulfonyloxyimid, die unter aktinischer Bestrahlung mit 200-600 nm Wellenlänge eine Sulfonsäure freigeben, enthält,

enthält, in einem vorgegebenen Muster mit aktinischem Licht bestrahlt, wodurch das Stoffgemisch an den bestrahlten Stellen in wässrigen basischen Entwicklern löslicher wird als an den nicht bestrahlten Stellen, und

(ii) das Stoffgemisch an den bestrahlten Stellen durch Behandlung mit dem wässrigen basischen Entwickler entfernt.

Ebenfalls Gegenstand der Erfindung sind lichtempfindliche Stoffgemische zur Durchführung des erfindungsgemässen Verfahrens, die

(A) ein filmbildendes organisches Material und

(B) einen Sulfonsäureester eines aromatischen Alkohols mit einer Carbonylgruppe oder ein aromatisches N-Sulfonyloxyimid, die unter aktinischer Bestrahlung mit 200-600 nm Wellenlänge eine Sulfonsäure freigeben, enthält,

enthalten, wobei das Stoffgemisch im wesentlichen frei von ethylenisch ungesättigtem Material, das in Gegenwart freier Radikale polymerisiert und im wesentlichen frei von Material ist, das in Gegenwart von Sulfonsäuren polymerisiert.

Die unter aktinischer Bestrahlung Sulfonsäure freigebende Substanz ist bevorzugt ein Sulfonsäureester

eines aromatischen Alkohols mit einer Carbonylgruppe in alpha- oder beta-Stellung zur Sulfonsäureestergruppe Dabei enthält das Derivat eine aromatische Gruppe und zwar ein Ringsystem mit 4p + 2 Pi-Elektronen, worin p die Zahl der Ringe in dem System bedeutet, wie beispielsweise heterocyclische aromatische Gruppen, wie die Pyridyl-, Furyl- und Thienylgruppe, oder Benzolstrukturen, wie die Phenyl-, Naphthyl- und Phenanthrylgruppe.

Als Sulfonsäureester eignen sich z.B. Verbindungen der Formel I oder II

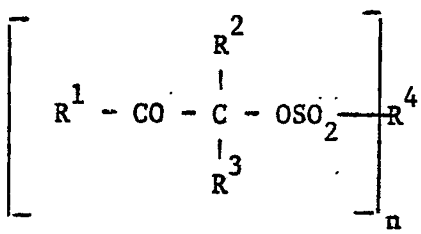

(I)

oder

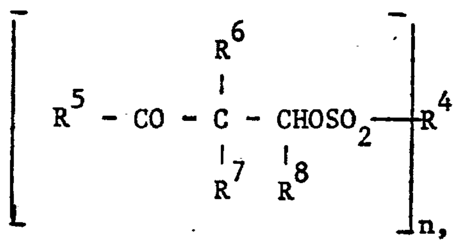

(II)

worin n 1 oder 2 ist,
$R^1$ Phenyl oder Naphthyl, das unsubstituiert oder durch 1, 2 oder 3 -Cl, -Br, -CN, $-NO_2$, $C_{1-12}$-Alkyl, $C_{1-4}$-Alkoxy, Phenyloxy, Tolyloxy, Phenylthio, Tolylthio, $C_{1-8}$-Alkylthio, $-SCH_2CH_2OH$, $C_{1-4}$-Alkylsulfonyl, Phenylsulfonyl, $C_{2-4}$-Alkoxycarbonyl, $C_{1-4}$-Alkylamino, $C_{2-4}$-Dialkylamino, Phenyl-CONH-, $C_{1-4}$-Alkyl-CONH- oder Benzoyl substituiert ist, oder Anthryl, Phenanthryl, Thienyl, Pyridyl, Furyl, Indolyl oder Tetrahydronaphthyl bedeutet,
$R^2$ und $R^3$ unabhängig voneinander Wasserstoff oder unsubstituiertes oder durch -OH, -Cl, $C_{1-4}$-Alkoxy, -CN, $-C_{2-5}$-Alkoxycarbonyl, Phenyl, Chlorphenyl, $C_{7-10}$-Alkylphenyl oder $C_{7-10}$-Alkoxyphenyl substituiertes $C_{1-8}$-Alkyl oder Benzoyl bedeuten und $R^3$ zudem Phenyl sein kann, das unsubstituiert oder durch -Cl, $c_{1-4}$-Alkyl, $C_{1-4}$-Alkoxy oder $C_{1-4}$-Alkylthio substituiert ist, oder $R^3$ $C_{2-8}$-Alkoxycarbonyl, -CN, $C_{1-4}$-Alkyl-NH-CO-, Phenyl-NH-CO- oder $-CONH_2$ ist, oder $R^2$ und $R^3$ zusammen mit dem Kohlenstoffatom, an das sie gebunden sind, einen $C_{4-6}$-Cycloalkylring bilden,
$R^4$ bei n = 1 $C_{1-18}$-Alkyl, unsubstituiertes oder durch Halogen, $C_{1-12}$-Alkyl, $C_{1-4}$-Alkoxy, $C_{1-4}$-Alkyl-CONH-, Phenyl-CONH-, $-NO_2$ oder Benzoyl substituiertes Phenyl, unsubstituiertes oder durch Halogen, $C_{1-12}$-Alkyl oder $C_{1-4}$-Alkoxy substituiertes Naphthyl, $C_{5-6}$-Cycloalkyl, $C_{7-9}$-Aralkyl, . Campheryl, $-CF_3$, $-CCl_3$, -F oder $-NH_2$ und bei n = 2 $-(CH_2)_m-$ mit m = 2-8, unsubstituiertes oder durch $C_{1-15}$-Alkyl substituiertes Phenylen oder Naphthylen bedeutet,
$R^5$ unsubstituiertes oder durch 1, 2 oder 3 von -Cl, -Br, $-C_{1-12}$-Alkyl, Phenyl, $C_{1-8}$-Alkoxy, Phenyloxy, Benzyloxy, $C_{1-8}$-Alkylthio, Phenylthio, $-SCH_2CH_2OH$, $-C_{1-4}$-Alkyl-CONH-, Benzoylamino, Dimethylamino oder Benzoyl substituiertes Phenyl oder Naphthyl, Anthryl oder Phenanthryl ist,
$R^6$ Wasserstoff, -OH, $C_{1-4}$-Alkoxy, $-OSi(CH_3)_3$, $-OCOCH_3$ oder unsubstituiertes oder durch Phenyl substituiertes $C_{1-8}$-Alkyl darstellt,
$R^7$ Wasserstoff, unsubstituiertes oder durch Phenyl substituiertes $C_{1-8}$-Alkyl, -CN, Benzoyl, $C_{1-4}$-Alkylcarbonyl, $C_{2-5}$-Alkoxycarbonyl oder Phenyl bedeutet,
$R^8$ Wasserstoff, unsubstituiertes oder durch -OH, -Cl oder Phenyl substituiertes $C_{1-8}$-Alkyl, unsubstituiertes oder durch -OH, -Cl, $C_{1-4}$-Alkyl oder $C_{1-4}$-Alkoxy substituiertes Phenyl, $C_{2-6}$-Alkenyl, $C_{8-9}$-Phenylalkenyl, Furyl, Thienyl, $-CCl_3$, $C_{5-6}$-Cycloalkyl oder $C_{5-6}$-Cycloalkanyl ist, oder worin
$R^5$ und $R^7$ oder $R^6$ und $R^7$ zusammen mit der Kohlenstoffstruktur, an welche sie gebunden sind, einen 5- oder 6-gliedrigen Ring mit 1 bis 5 $-CH_2-$, $-CH(CH_3)-$, $-C(CH_3)_2-$, -O-, -S-, -SO-, $SO_2$-, -CO-, $-N(CO-C_{1-4}$-Alkyl)- oder $-N(COC_5H_6)$-Gruppen bilden.

Besonders bevorzugt sind Sulfonsäureester der Formel I oder II, worin n 1 ist, $R^1$ unsubstituiertes oder durch Chlor, Methyl, Methoxy, Methylthio, Phenylthio, $-SCH_2CH_2OH$ oder Benzoyl substituiertes Phenyl, $R^2$ Wasserstoff oder $C_{1-4}$-Alkyl, $R^3$ Wasserstoff, $C_{1-4}$-Alkyl oder Phenyl, oder $R^2$ und $R^3$ zusammen mit dem Kohlenstoffatom, an das sie gebunden sind, einen Cyclohexanring, $R^4$ $C_{1-18}$-Alkyl, unsubstituiertes oder durch $C_{1-12}$-Alkyl substituiertes Phenyl oder Naphthyl oder Campheryl, $R^5$ unsubstituiertes oder durch -Cl, $C_{1-4}$-Alkoxy, $-SCH_3$ oder Phenyl substituiertes Phenyl, $R^6$ -OH oder $C_{1-4}$-Alkyl, $R^7$ $C_{1-4}$-Alkyl oder Phenyl und $R^8$ H, $C_{1-4}$-Alkyl, Furyl oder $-CCl_3$ bedeutend oder $R^7$ und $R^8$ zusammen mit dem Kohlenstoffatom, an das sie gebunden sind, einen Cyclohexanring bilden.

Ganz besonders bevorzugt sind Sulfonsäureester der Formel I und II, worin n = 1 ist, $R^1$ und $R^5$ je Phenyl, p-Tolyl oder p-Methylthiophenyl, $R^2$ Wasserstoff, $R^3$ Methyl, Isopropyl, Phenyl, n-Decyl oder

Benzyl, $R^4$ Phenyl, p-Tolyl oder p-n-Dodecylphenyl, $R^6$ -OH, $R^7$ $-CH_3$ oder Phenyl und $R^8$ Wasserstoff bedeuten.

Die erwähnten Sulfonsäureester von hydroxylgruppenhaltigen alpha- oder beta-ketonen und deren Herstellung sind in der britischen Patentanmeldung Nr. 2120263A beschrieben. Darin wird auch deren Verwendung als latente Sulfonsäurequellen beschrieben, wobei die Sulfonsäuren unter der Einwirkung von aktinischer Strahlung zum Härten von Aminoplasten oder Phenoplasten freigesetzt werden.

Weitere geeignete Sulfonsäureester sind solche der Formel III

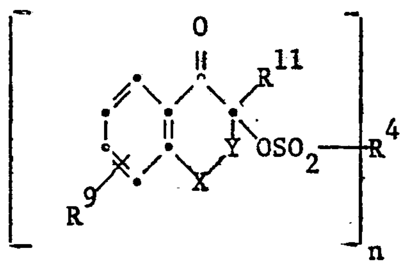

(III),

worin n und $R^4$ die oben angegebene Bedeutung haben,
$R^9$ ein Wasserstoffatom oder 1, 2 oder 3-Cl, -Br, $-NO_2$, $C_{1-12}$-Alkyl-, $C_{1-4}$-Alkoxy-, Phenoxy-, Phenylthio-, $C_{1-8}$-Alkylthio- oder $-SCH_2OH$-Substituenten darstellt,
X -O-, -S-, $-SO_2-$, $-CH_2-$, $-C(CH_3)_2-$ oder $-NCOR^{10}$ ist,
worin $R^{10}$ $C_{1-4}$-Alkyl oder Phenyl darstellt,
Y die direkte Bindung oder $-CH_2-$ ist und
$R^{11}$ ein Wasserstoffatom, $C_{1-8}$-Alkyl, das durch -OH, -Cl, $C_{1-4}$-Alkoxy, -CH, $C_{2-5}$-Alkoxycarbonyl, Phenyl, Chlorphenyl, $C_{7-10}$-Alkylphenyl oder $C_{1-10}$-Alkoxyphenyl substituiert sein kann, Phenyl, das durch -Cl, $C_{1-4}$-Alkyl, $C_{1-4}$-Alkoxy oder $C_{1-4}$-Alkylthio substituiert sein kann, $C_{2-8}$-Alkoxycarbonyl oder -CN darstellt.

Besonders bevorzugt sind Sulfonsäureester der Formel III, worin n 1 ist, $R^9$ und $R^{11}$ Wasserstoff, X und Y je $-CH_2-$ und $R^4$ $C_{1-18}$-Alkyl, das durch Phenyl oder Naphthyl substituiert sein kann, oder eine Campherylgruppe darstellen.

Derartige Sulfonsäureester sind in der europäischen Patentveröf-fentlichung A-O 084 515 als strahlungsaktivierte latente Sulfonsäurequellen für das Härten von Phenoplasten, Aminoplasten oder Gemischen aus Aminoplasten und hydroxylgruppenhaltigen Polyacrylaten, Polyestern und Alkydharzen beschrieben.

Weitere geeignete Sulfonsäureester sind Sulfonsäureester von alpha-Methylolbenzoinen oder deren Ethern der Formel IV

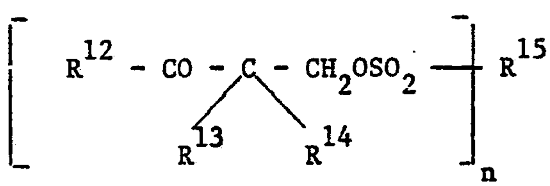

(IV),

worin n die oben angegebene Bedeutung hat,
$R^{12}$ und $R^{13}$ unabhängig voneinander Phenyl, das durch $C_{1-4}$-Alkyl, $C_{1-4}$-Alkoxy, Halogen, Phenyl oder Dialkylamino mit je 1-4 C-Atomen substituiert sein kann, wobei die Dialkylaminogruppen durch eine OH-Gruppe substituiert sein können, $R^{14}$ unsubstituiertes oder substituiertes $C_{5-18}$-Alkyl, $C_{2-18}$-Alkenyl, $C_{5-8}$-Cycloalkyl oder -Cycloalkenyl, unsubstituiertes oder substituiertes $C_{6-20}$-Aryl, Furyl, oder eine Gruppe -(E)-CH-OZ, worin E $-CH_3$ und Z $C_{2-4}$-Alkyl darstellen oder E und Z zusammen eine 1,3- oder 1,4-Alkylengruppe mit 3 oder 4 Kohlenstoffatomen, die durch eine $C_{1-4}$-Alkoxygruppe substituiert sein kann, und $R^{15}$ unsubstituiertes oder substituiertes $C_{1-20}$-Alkyl, $C_{4-20}$-Alkenyl, $C_{5-8}$-Cycloalkyl, $C_{5-8}$-Cycloalkenyl, Phenyl, Tolyl, Naphthyl, Alkaryl mit 4-16 C-Atomen in der Alkylgruppe, Furfuryl, $C_{6-10}$-Arylen oder $C_{1-6}$-Alkylen bedeuten.

Derartige Sulfonsäureester sind in der europäischen Patentveröffentlichung A-0037512 als Photoinitiatoren für die Photopolymerisation von Verbindungen mit aktivierten ethylenischen Doppelbindungen und als Sulfonsäurequellen bei Härten von säure-härtbaren Harzen oder Harz-Zusammensetzungen, wie phenolische Harze und Aminoplaste, beschrieben.

Es können auch aromatische N-Sulfonyloxyimide der Formel V

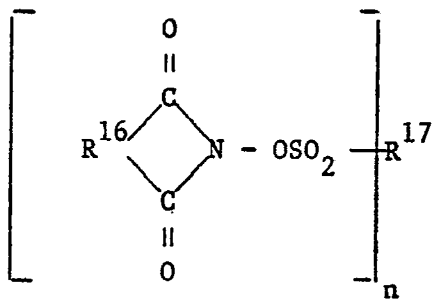

(V)

verwendet werden, worin n die oben angegebene Bedeutung hat, $R^{16}$ Arylen, substituiertes Arylen, Alkylen, substituiertes Alkylen, Alkenylen, substituiertes Alkenylen, geradkettiges, verzweigtes oder cyclisches Alkylen mit 2-6 C-Atomen, das durch Phenyl, Naphthyl oder $C_{1-4}$-Alkyl substituiert sein kann oder unsubstituiertes oder durch Phenyl oder $C_{1-2}$-Alkyl substituiertes $C_{2-4}$-Alkenylen und $R^{17}$ bei n = 1 geradkettiges oder verzweigtes, unsubstituiertes oder durch Halogen oder $C_{1-4}$-Alkoxy substituiertes $C_{1-18}$-Alkyl, unsubstituiertes oder durch $C_{1-15}$-Alkyl, $C_{1-4}$-Alkyl-CONH-, Phenyl-CONH- oder $-NO_2$ substituiertes $C_{6-12}$-Aryl, $C_{5-6}$-Cycloalkyl, Campheryl, $-CF_3$, $-CCl_3$, $-CH_2Cl$, -F oder $-NH_2$ und bei n = 2 $C_{2-6}$-Alkylen, Phenylen oder Naphthylen bedeuten, mit der Massgabe, dass mindestens eines von $R^{16}$ und $R^{17}$ eine aromatische Gruppe bedeutet oder eine aromatische Gruppe enthält.

In Formel V ist $R^{16}$ vorzugsweise o-Phenylen, 1,2-, 2,3- oder 1,8-Naphthylen, die durch ein Chlor- oder Bromatom, eine Nitro-, $C_{1-8}$-Alkyl-, $C_{1-4}$-Alkoxy-, $C_{1-12}$-Alkylthio oder eine Phenylthio-Gruppe substituiert sein können, oder $R^{16}$ ist eine Ethylen-, Propylen-, Cyclobutylen-, Cyclohexylen-, Phenylethylen- oder Vinylidengruppe, n ist 1 und $R^{17}$ bedeutet eine $C_{6-10}$-Arylgruppe, die durch eine $C_{1-12}$-Alkylgruppe oder ein Chloratom substituiert sein kann.

Verbindungen der Formel V sind in den U.S. Patentschriften Nr. 4 258 121 und 4 371 605 und in der europäischen Patentveröffentlichung A-0058638 beschrieben. Gemäss der ersten dieser Literaturstellen werden sie für die Photopolymerisation von Monomeren mit mindestens zwei ethylenisch ungesättigten Gruppen, eingesetzt. Die U.S. Patentschrift 4 371 605 beschreibt deren Verwendung als Photopolymerisationsmittel für Verbindungen mit einer oder zwei ethylenisch ungesättigten Gruppen für Stoffzusammensetzungen, die durch Ringöffnung cyclischer Gruppen, wie Lactone oder Epoxide, polymerisieren, sowie für Melaminharze. Gemäss der dritten Literaturstelle werden sie als latente Härtungskatalysatoren für säurehärtbare Einbrennlacke, besonders solche auf der Basis von Aminoplasten und OH-gruppenhaltigen Acrylaten oder auf der Basis von Phenoplasten, verwendet.

Es können auch aromatische N-Sulfonyloxyamide der Formel VI

$$\left[ R^{18}CON(R^{19})-OSO_2 \right]_n R^{17} \qquad \text{(VI)}$$

verwendet werden, worin $R^{17}$ und n die oben angegebene Bedeutung haben.

$R^{18}$ eine aliphatische, cycloaliphatische oder aromatische Gruppe ist, besonders Phenyl, Naphthyl, Anthryl, oder $C_{6-14}$-Aryl darstellt, das durch $C_{1-4}$-Alkyl, -Cl, -Br, -F, $C_{1-2}$-Alkoxy, -CN, $-NO_2$, Dimethylamino, Benzoyl, $-OCH_2C_6H_5$, $-OCF_3$ oder Phenyl substituiert ist, und $R^{19}$ Wasserstoff, $C_{1-4}$-Alkyl oder $R^{18}CO$-darstellt, wobei mindestens eines von $R^{18}$ und $R^{19}$ eine aromatische Gruppe enthält oder eine aromatische Gruppe ist.

Verbindungen der Formel VI sowie deren Verwendung bei der Photopolymerisation von ethylenisch ungesättigten Verbindungen, für Stoffzusammensetzungen, die durch Ringöffnung einer cyclischen Gruppe, wie Lactone und Epoxide, polymerisieren, und für Melaminharze sind in der U.S. Patentschrift Nr. 4 371 605 beschrieben.

Die am meisten bevorzugten sulfonsäurefreisetzenden Verbindungen (B) sind Sulfonsäureester von Benzoin oder alpha-Methylolbenzoin, insbesondere Benzoin-p-toluolsulfonat und 3-(p-Toluolsulfonyloxy)-2-hydroxy-2-phenyl-1-phenyl-1-propanon sowie N-Sulfonyloxy-Derivate von 1,8-Naphthalimid, besonders N-Benzolsulfonyloxy- und N-(p-Dodecylbenzolsulfonyloxy)-1,8-naphthalimid.

Bevorzugt verwendet man 0,05 bis 0,8, besonders etwa 0,2 bis 0,6 Gewichtsteile der Sulfonsäure freigebenden Substanz, bezogen auf das Gewicht des filmbildenden organischen Materials.

Als filmbildende organische Materialien, die in wässriger Base löslich sind, verwendet man bevorzugt

Verbindungen mit Phosphonsäuregruppen und besonders Materialien mit phenolischen Hydroxylgruppen oder Carbonsäure-, Sulfonsäure- oder Phosphorsäuregruppen.

Beispiele derartiger Materialien sind Novolakharze aus einem Aldehyd, wie Acetaldehyd oder Fufuraldehyd und bevorzugt Formaldehyd und Phenolen, wie Phenol selbst, mit einem oder zwei Chloratomen substituierte Phenole, wie p-Chlorphenol, oder Phenole, die mit 1 oder 2 Alkylgruppen mit 1-9 C-Atomen substituiert sind, wie z.B. o-, m- und p-Kresol, die Xylenole, p-tert-Butylphenol und p-Nonylphenol, ferner p-Phenylphenol, Resorcin, Bis(4-hydroxyphenyl)methan und 2,2-Bis(4-hydroxyphenyl)propan.

Als weitere geeignete Materialien seien Homopolymere und Copolymere von ethylenisch ungesättigten Carbonsäuren und Carbonsäureanhydriden genannt. Beispiele solcher Materialien sind Homopolymere von Acryl- und Methacrylsäure und Copolymere dieser Säure mit z.B. aliphatischen ungesättigten Verbindungen, wie Ethylen, Propylen, Acryl- und Methacrylsäureestern, Vinylestern, wie Vinylacetat, und vinylaromatischen Verbindungen, wie Styrol und substituierte Styrole. Andere geeignete Polymere sind Styrol-Maleinsäureanhydrid-Copolymere.

Es können auch Polyester mit endständigen Carboxylgruppen eingesetzt werden, wie die Reaktionsprodukte aus zweiwertigen Alkoholen und Dicarbonsäuren. Als zweiwertige Alkohole eignen sich z.B. Ethylenglykol, Diethylenglykol und höhere Polyoxyethylenglykole, Propan-1,2-diol, Dipropylenglykol und höhere Polyoxypropylenglykole, Propan-1,3-diol, Butan-1,4-diol und Polyoxytetramethylenglykole, Pentan-1,5-diol, Resorcit(1,3-Cyclohexandiol), Chinit(1,4-Cyclohexandiol), Bis(4-hydroxycyclohexyl)methan, und 2,2-Bis(4-hydroxycyclohexyl)propan.Als Dicarbonsäuren kommen z.B. aliphatische Säuren, wie Bernsteinsäure, Glutarsäure, Adipinsäure, Pimelinsäure, Suberinsäure, Azelainsäure oder Sebacinsäure, dimerisierte Linolsäure, aromatische Säuren, wie Phthalsäure, Isophthalsäure und Terephthalsäure, sowie cycloaliphatische Säuren, wie Hexahydrophthalsäure, in Betracht.

Ebenfalls geeignet sind säuregruppenhaltige Addukte aus Polyepoxiden mit im Durchschnitt mehr als einer 1,2-Epoxidgruppe pro Molekül und Polycarbonsäuren, besonders Dicarbonsäuren, oder Substanzen, die Carbonsäure-, Sulfonsäure-, Phosphonsäure- oder Phosphorsäuregruppen und auch Gruppen enthalten, die unter den Reaktionsbedingungen für die Addukt-Bildung bevorzugt mit den Epoxidgruppen des Polyepoxids reagieren. Als solche Gruppen kommen zweckmässig primäre oder sekundäre aliphatische oder aromatische Aminogruppen oder Mercaptogruppen in Betracht. Für die Addukt-Bildung eignen sich z.B. aliphatische, cycloaliphatische und aromatische Dicarbonsäuren, wie Adipinsäure, Hexahydrophthalsäure und Phthalsäure; Aminocarbonsäuren, wie Glyzin, Asparaginsäure, Sarkosin und p-Aminobenzoesäure; Aminosulfonsäuren, wie Sulfanilsäure und Metanilsäure; Aminophosphonsäuren, wie 2-Amino-1-phenylethylphosphonsäure und 1-Aminoethylidenbis(phosphonsäure);Mercaptocarbonsäuren, wie Thioglykolsäure und Mercaptopropionsäuren. Als Polyepoxide eignen sich z.B. Polyclycidylether, besonders Diglycidylether, von mehrwertigen, vor allem zweiwertigen Phenolen, wie z.B. einkernige Phenolen, wie Resorcin, aber bevorzugt Bisphenolen, wie Bis(4-hydroxyphenyl)methan und 2,2-Bis(4-hydroxyphenyl)propan; Polyglycidylether, besonders Diglycidylether, von mehrwertigen, besonders zweiwertigen Alkoholen, wie z.B. Ethylenglykol, Butan-1,4-diol und 2,2-Bis(4-hydroxycyclohexyl)propan; und Diglycidylester von aliphatischen, cycloaliphatischen und aromatischen Dicarbonsäuren, wie Bernsteinsäure, Hexahydrophthalsäure und Phthalsäure.

Die Herstellung von carboxylgruppenhaltigen Addukten aus Polyepoxiden und Aminocarbonsäuren ist in den U.S. Patentschriften Nr. 4 098 744, und 4 332 709, während die Herstellung von Addukten aus Polyepoxiden und neutralisierten Aminosulfonsäuren in den U.S. Patentschriften Nr. 4 317 757 und 4 332 709 beschrieben ist. Die Umsetzung von Polyepoxiden mit Mercaptocarbonsäuren zu carboxylgruppenhaltigen Addukten ist in der U.S. Patentschrift Nr. 4 153 586 beschrieben.

Die Bilderzeugung kann durch Zusatz eines Photosensibilisators zum Stoffgemisch beschleunigt werden, d.h. Verbistdungen, die unter Bestrahlung in einen angeregten Zustand übergehen und die Energie exothermisch auf die nicht angeregte latente Sulfonsäurequelle übertragen. Als Photosensibilisatoren kommen z.B. kondensierte aromatische Kohlenwasserstoffe und deren substituierte Derivate, aromatische Carbonylverbindungen, aromatische Nitroverbindungen und kationische oder basische Farbstoffe in Betracht. Spezifische Klassen geeigneter Photosensibilisatoren sind z.B. Anthracene, Fluranthene, Pyrene, Anthrone, Thioxanthone, wie das 2-Methyl- oder 2-Chlorthioxanthon, und Benzophenone, besonders Bis-(dialkylamino) benzophenone, wie das 4,4'-Bis(dimethylamino)benzophenon (Michler's Keton). Dem Stoffgemisch kann auch ein Farbstoff, wie z.B. Kristallviolett, beigegeben werden, wodurch das Bild leichter erkennbar ist.

Bei der Ausführung des erfindungsgemässen Verfahrens kann eine Schicht des Stoffgemisches, aus dem das Bild erzeugt werden soll, in an sich bekannter Weise aus einem Lösungsmittel auf ein Trägermaterial appliziert werden. Als Lösungsmittel eignen sich z.B. 2-Ethoxyethanol, 2-Ethoxyethylacetat, Ethylmethylketon, N-methylpyrrolidon, Dimethylformamid oder Gemische davon. Das Auftragen der Schicht kann durch Tauchen, Schleuderbeschichtung, Sprühen oder durch Walzenauftrag erfolgen. Anschliessend lässt

man das Lösungsmittel verdampfen, oder das Lösungsmittel wird verdampft, z.B. durch Trocknen an der Luft oder durch Erhitzen auf Temperaturen unterhalb der Härtungstemperatur von hitzehärtbaren Bestandteilen. Als Trägermaterial werden im allgemeinen Kupfer, Aluminium oder andere Metalle, Silizium, Siliziumoxide oder -nitride, synthetische Harze oder Kunststoffe, wie Polyesterfilme, Polyamide, Polyolefine, Papier oder Glas verwendet. Die Beschichtung erfolgt zweckmässig so, dass nach dem Trocknen eine etwa 1-250 mikrometer dicke Schicht entsteht.

Das Bestrahlen des Stoffgemisches mit aktinischem Licht in einem vorgegebenen Muster kann durch Belichten durch ein ein Bild aufweisendes transparentes Material, das aus im wesentlichen opaken und im wesentlichen transparenten Bereichen besteht, oder mit einem computergesteuerten Laserstrahl vorgenommen werden. Im allgemeinen wird aktinisches Licht mit 200-600 nm Wellenlänge verwendet. Als Lichtquellen eignen sich z.B. Kohlebögen, Quecksilberdampflampen, fluoreszierende Lampen mit ultraviolettem Licht emittierenden Phosphoren, Argon- und Xenonglühlampen, Wolframlampen und photographische Flutlichtlampen. Quecksilberdampflampen und Metallhalogenidlampen sind am besten geeignet. Die erforderliche Belichtungszeit hängt von verschiedenen Faktoren ab, wie der Art der verwendeten Zusammensetzung, der Schichtdicke, der Art der Lichtquelle und deren Abstand von der Schicht. Sie beträgt im allgemeinen zwischen 30 Sekunden und 4 Minuten, die geeignete Zeit kann jedoch leicht mittels Routine-Versuchen ermittelt werden.

Nach der bildmässigen Belichtung wird die Schicht mit einem Entwickler gewaschen, um die belichteten Stellen, d.h. die bestrahlten Bereiche, zu entfernen. Dabei bleiben die nicht bestrahlten Bereiche unverändert. Der Entwickler löst die bestrahlten Stellen oder macht sie leichter entfernbar durch sanftes Bürsten oder Schütteln.

Als wässriger basischer Entwickler können wässrige Lösungen einer starken Base, wie Triethylamin, verwendet werden. Bevorzugt sind jedoch wässrige alkalische Lösungen, z.B. solche, die Natriumhydroxid, Natriumcarbonat oder Dinatriumhydrogenphosphat enthalten. Zur Beschleunigung des Entwicklungsvorganges können kleine Mengen, z.B. 5-15 Vol. %, eines mit Wasser mischbaren niederen aliphatischen Alkohols, wie Methanol, zugegeben werden.

Nach dem Belichten und Entwickeln kann das Substrat geätzt werden, um entweder bei der Herstellung von gedruckten Schaltungen das Metall von den belichteten Stellen zu entfernen, oder um die Bildtiefe und damit die Abhebung des Bildes zu vergrössern. Dabei schützt die verbleibende Beschichtung an den nicht bestrahlten Stellen das darunter liegende Substrat. Geeignete Aetzverfahren, z.B. unter Verwendung von Eisen(III)chlorid- oder Ammoniumpersulfat-Lösungen auf Kupfer, sind bekannt. Falls erwünscht, kann das ganze Substrat in nicht bildmässiger Weise während einer längeren Zeit nocht einmal bestrahlt werden. Dabei wird die verbliebene Beschichtung in basischen Lösungen löslich und das darunter liegende Substrat wird freigelegt.

Das erfindungsgemässe Verfahren eignet sich zur Herstellung von Druckplatten und gedruckten, integrierten oder Hydrid-Schaltungen.

In den folgenden Beispielen sind Teile Gewichtsteile, sofern nichts anderes angegeben ist.

Beispiel 1: Es wird eine Lösung aus 4 Teilen eines Kresol-Novolak-Gemisches mit einem Erweichungspunkt von 136 °C und 2 Teilen Benzoin-p-toluolsulfonat in 6 Teilen Dimethylformamid (DMF) hergestellt. Zu dieser Lösung gibt man, um das Bild klarer sichtbar zu machen, eine 2%ige Lösung von Kristallviolett in DMF. Mit dem Gemisch wird ein gereinigtes kupferkaschiertes Laminat mittels Schleuderbeschichtung so beschichtet und während 2 Minuten bei 90 °C getrocknet, dass eine 8 Mikrometer dicke Beschichtung entsteht. Die Beschichtung wird während 1 Minute durch ein Negativ mit einer 5000 w Metallhalogenidlampe in einem Abstand von 75 cm belichtet. Durch 90 Sekunden langes Entwickeln mit einer 2%igen wässrigen Natriumhydroxidlösung erhält man ein gutes Bild.

Beispiel 2: Es wird eine Lösung aus 4 Teilen eines Kresol-Novolak-Gemisches mit einem Erweichungspunkt von 136 °C und 2 Teilen 3-(p-Toluolsulfonyloxy)-2-hydroxy-2-phenyl-1-phenyl-1-propanon, d.h. alpha-(p-Toluolsulfonyloxy)methylbenzoin, in 6 Teilen DMF hergestellt. Diese Lösung wird mit 2 Teilen einer 2%igen Lösung von Kristallviolett in DMF versetzt. Mit diesem Gemisch wird ein gereinigtes kupferkaschiertes Laminat so beschichtet und während 2 Minuten bei 90 °C getrocknet, dass eine 15 Mikrometer dicke Schicht entsteht. Die Beschichtung wird während 1 Minute durch ein Negativ mit einer 5000 w Metallhalogenidlampe in einem Abstand von 75 cm bestrahlt. Durch Entwicken während 25 Sekunden mit einer 2%igen wässrigen Natriumhydroxidlösung erhält man ein gutes Bild.

Beispiel 3: Es wird eine Lösung aus 3 Teilen eines Styrol-Maleinsäureanhydrid-Copolymers (SCRIPSET 520®, Molekulargewicht 1300, Mol-Verhältnis 4:1, erhältlich von der Fa. Cairn Chemicals Ltd.) und 1 Teil 3-(p-Toluolsulfonyloxy)-2-hydroxy-2-phenyl-1-phenyl-1-propanon in 12 Teilen DMF hergestellt. Diese Lösung wird mit 3 Teilen einer 2%igen Lösung von Kristallviolett in DMF versetzt. Mit diesem Gemisch wird ein gereinigtes kupferkaschiertes Laminat so beschichtet und während 2 Minuten bei 90 °C getrocknet, dass

eine 7 Mikrometer dicke Schicht entsteht. Die Beschichtung wird während 1 Minute durch ein Negativ mit einer 5000 w Metallhalogenidlampe in einem Abstand von 75 cm bestrahlt. Durch 1-minütiges Entwickeln mit einer 1%igen wässrigen Natriumhydroxidlösung erhält man ein gutes Bild.

Beispiel 4: Es wird eine Lösung aus 4 Teilen eines Kresol-Novolak-Gemisches mit einem Erweichungspunkt von 136° C und 2 Teilen N-(p-Dodecylbenzolsulfonyloxy)-1,8-naphthalimid in 6 Teilen eines Lösungsmittelgemisches aus 2-Ethoxyethanol, 2-Ethoxyethylacetat und Ethylmethylketon(Volumenverhältnis 2:2:1) hergestellt. Diese Lösung wird mit einer 2%igen Lösung von Kristallviolett in dem oben erwähnten Lösungsmittelgemisch versetzt. Mit diesem Gemisch wird ein gereinigtes kupferkaschiertes Laminat so beschichtet und während 5 Minuten bei 90° C getrocknet, dass eine 14 Mikrometer dicke Schicht entsteht. Die Beschichtung wird während 2 Minuten durch ein Negativ mit einer 5000 w Metallhalogenidlampe in einem Abstand von 75 cm bestrahlt. Es wird während 3 Minuten mit einem Gemisch aus 2%iger wässriger Natriumhydroxidlösung und Methanol im Volumenverhältnis 90:10 entwickelt. Man erhält ein gutes Bild.

Beispiel 5: Es wird eine Lösung aus 4 Teilen eines tert-Butylphenol-Phenol-Novolaks (Verhältnis 30:70, Erweichungspunkt 127° C) und 2 Teilen N-(p-Dodecylbenzolsulfonyloxy)-1,8-naphthalimid in 6 Teilen des in Beispiel 4 beschriebenen Lösungsmittelgemisches hergestellt. Diese Lösung wird mit einer 2%igen Lösung von Kristallviolett in dem genannten Lösungsmittelgemisch versetzt. Mit diesem Gemisch wird ein gereinigtes kupferkaschiertes Laminat so beschichtet und während 5 Minuten bei 90° C getrocknet, dass eine 14 Mikrometer dicke Schicht entsteht. Die Beschichtung wird während 2 Minuten durch ein Negativ mit einer 5000 w Metallhalogenidlampe in einem Abstand von 75 bestrahlt. Nach dem Entwickeln während 40 Sekunden mit einem Gemisch aus einer 2%igen wässrigen Natriumhydroxidlösung und Methanol (90:10 Volumenverhältnis) erhält man ein gutes Bild.

Beispiel 6: Es wird eine Lösung aus 5 Teilen eines Kresol-Novolak-Gemisches mit einem Erweichungspunkt von 119° C und 1 Teil N-(Benzolsulfonyloxy)-1,8-naphthalimid in 12 Teilen DMF hergestellt. Diese Lösung wird mit 1 Teil einer 2%igen Lösung von Kristallviolett in DMF versetzt. Mit diesem Gemisch wird ein gereinigtes kupferkaschiertes Laminat so beschichtet und während 5 Minuten bei 90° C getrocknet, dass eine 5 Mikrometer dicke Schicht entsteht. Die Beschichtung wird während 2 Minuten durch ein Negativ mit einer 5000 w Metallhalogenidlampe in einem Abstand von 75 cm bestrahtl. Durch 2-minü-tiges Entwickeln mit 2%iger wässriger Natriumhydroxidlösung erhält man ein gutes Bild. Das Bild kann mit 40%iger Eisen-(III)chlorid-Lösung während 3 Minuten bei 30° C geätzt werden, wobei die beschichteten Stellen intakt bleiben. Durch weiteres Bestrahlen während 2 Minuten ohne Negativ kann die verbliebene Beschichtung mit 2%iger Natriumhydroxidlösung entfernt werden, wodurch das darunter liegende Kupfermuster freigelegt wird.

Beispiel 7: Es wird eine Lösung aus 4 Teilen eines Acrylcopolymers aus Methylmethacrylat und Methacrylsäure (Mol-Verhältnis 75:25, Säurewert 2,18 Aequivalente/kg) und 2 Teilen 3-(p-Toluolsulfonyloxy)-2-phenyl-1-phenyl-1-propanon in 6 Teilen DMF hergestellt. Diese Lösung wird mit 2 Teilen einer 2%igen Lösung von Kristallviolett in DMF versetzt. Mit dem Gemisch wird ein gereinigtes kupferkaschiertes Laminat so beschichtet und während 3 Minuten bei 90° C getrocknet, dass man eine 12 Mikrometer dicke Schicht erhält. Die Beschichtung wird während 2 Minuten durch ein Negativ mit einer 5000 w Metallhalogenidlampe bestrahlt. Nach 40 Sekunden Entwickeln mit einer 1%igen wässrigen Natriumhydroxyidlösung erhält man ein gutes Bild. Das Bild kann mit einer 40%igen Lösung von $FeCl_3$ während 3 Minuten bei 30° C geätzt werden. Durch weiteres Bestrahlen während 2 Minuten ohne Negativ kann die verbliebene Beschichtung mit 2%iger wässriger Natriumhydroxidlösung entfernt werden, wodurch das darunter liegende Kupfermuster freigelegt wird.

Beispiel 8: Mit der gemäss Beispiel 7 hergestellten Lösung wird Aluminium so beschichtet und während 3 Minuten bei 90° C getrocknet, dass man eine 10 Mikrometer dicke Schicht erhält. Die Beschichtung wird während 2 Minuten durch ein Negativ mit einer 5000 w Metallhalogenidlampe bestrahlt. Nach 50 Sekunden Entwickeln mit einer 1%igen wässrigen Natriumhydroxidlösung erhält man ein gutes Bild.

Beispiel 9: Es wird eine Lösung aus 4 Teilen eines Kresol-Novolak-Gemisches mit einem Erweichungspunkt von 136° C, 2 Teilen N-(p-Dodecylbenzolsulfonyloxy)-1,8-naphthalimid und 0,2 Teilen Michler's Keton (als Sensibilisator) in 6 Teilen des in Beispiel 4 beschriebenen Lösungsmittelgemisches hergestellt. Diese Lösung wird mit einer 2%igen Lösung von Kristallviolett in dem genannten Lösungsmittelgemisch versetzt. Mit dem Gemisch wird ein gereinigtes kupferkaschiertes Laminat so beschichtet und während 5 Minuten bei 90° C getrocknet, dass man eine 14 Mikrometer dicke Schicht erhält. Die Beschichtung wird während 2 Minuten durch ein Negativ mit einer 5000 w Metallhalogenidlampe in einem Abstand von 75 cm bestrahlt. Nach 2 Minuten Entwickeln mit einer 2%igen wässrigen Natriumhydroxidlösung erhält man ein gutes Bild.

**Patentansprüche**

1. Verfahren zur Bilderzeugung, dadurch gekennzeichnet, dass man
   (i) ein auf einem Trägermaterial befindliches Stoffgemisch, das
   (A) ein filmbildendes organisches Material und
   (B) einen Sulfonsäureester eines aromatischen Alkohols mit einer Carbonylgruppe oder ein aromatisches N-Sulfonyloxyimid, die unter aktinischer Bestrahlung mit 200-600 nm Wellenlänge eine Sulfonsäure freigeben, enthält,
   in einem vorgegebenen Muster mit aktinischem Licht bestrahlt, wodurch das Stoffgemisch an den bestrahlten Stellen in wässrigen basischen Entwicklern löslicher wird als an den nicht bestrahlten Stellen, und (ii) das Stoffgemisch an den bestrahlten Stellen durch Behandlung mit dem wässrigen basischen Entwickler entfernt.

2. Verfahren nach Anspruch 1, worin der Sulfonsäureester eine Verbindung der Formel I oder III

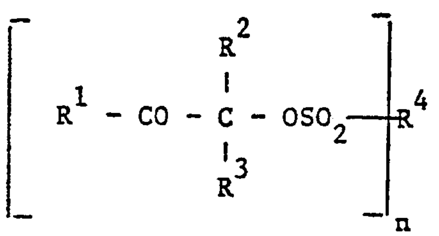

oder

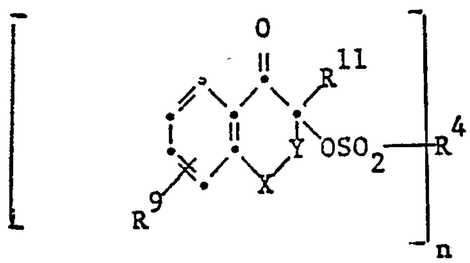

(I) (III)

ist, worin
n 1 oder 2 ist,
$R^1$ unsubstituiertes oder durch 1, 2 oder 3 von -Cl, -Br, -CN, -$NO_2$, $C_{1-12}$-Alkyl, $C_{1-4}$-Alkoxy, Phenyloxy, Tolyloxy, Phenylthio, Tolylthio, $C_{1-8}$-Alkylthio, -$SCH_2OH$, $C_{1-4}$-Alkylsulfonyl, Phenylsulfonyl, $C_{2-4}$-Alkoxycarbonyl, $C_{1-4}$-Alkylamino, $C_{2-4}$-Dialkylamino, Phenyl-CONH-, $C_{1-4}$-Alkyl-CONH- oder Benzoyl substituiertes Phenyl oder Naphthyl, Anthryl, Phenanthryl, Thienyl, Pyridyl, Furyl, Indolyl oder Tetrahydronaphthyl bedeutet,
$R^2$ und $R^3$ unabhängig voneinander Wasserstoff, unsubstituiertes oder durch -OH, -Cl, $C_{1-4}$-Alkoxy, -CN, $C_{2-5}$-Alkoxycarbonyl, Phenyl, Chlorphenyl, $C_{7-10}$-Alkylphenyl oder $C_{7-10}$-Alkoxyphenyl substituiertes $C_{1-8}$-Alkyl oder Benzoyl darstellen, R zusätzlich unsubstituiertes oder durch -Cl, $C_{1-4}$-Alkyl, $C_{1-4}$-Alkoxy oder $C_{1-4}$-Alkylthio substituiertes Phenyl, $C_{2-8}$-Alkoxycarbonyl, -CN, -$C_{1-4}$-Alkyl-NH-CO-, Phenyl-NH-CO-oder -$CONH_2$ sein kann, oder
$R^2$ und $R^3$ zusammen mit dem Kohlenstoffatom, an das sie gebunden sind, einen $C_{4-6}$-Cycloalkylring bilden,
$R^4$ bei n = 1 $C_{1-18}$-Alkyl, unsubstituiertes oder durch Halogen, $C_{1-12}$-Alkyl, $C_{1-4}$-Alkoxy, $C_{1-4}$-Alkyl-CONH-, Phenyl-CONH-, -$NO_2$ oder Benzoyl substituiertes Phenyl, unsubstituiertes oder durch Halogen, $C_{1-12}$-Alkyl oder $C_{1-4}$-Alkoxy substituiertes Naphthyl, $C_{5-6}$-Cycloalkyl, $C_{7-9}$-Aralkyl, Campheryl, -$CF_3$, -$CCl_3$, -F oder -$NH_2$ und bei n = 2 eine -$(CH_2)_m$-Gruppe mit m = 2-8, unsubstituiertes oder durch $C_{1-15}$-Alkyl substituiertes Phenylen oder Naphthylen darstellt,
$R^9$ ein Wasserstoffatom oder 1, 2 oder 3 -Cl, -Br, -$NO_2$, $C_{1-12}$-Alkyl-, $C_{1-4}$-Alkoxy-, Phenoxy-, Phenylthio-, $C_{1-8}$-Alkylthio oder -$SCH_2CH_2OH$-Substituenten darstellt,
X -O-, -S-, -$SO_2$- -$C(CH_3)_2$- oder -$NCOR^{10}$, worin
$R^{10}$ $C_{1-4}$-Alkyl oder Phenyl ist, bedeutet,
Y die direkte Bindung oder -$CH_2$- ist und
$R^{11}$ ein Wasserstoffatom, unsubstituiertes oder durch -OH, -Cl, $C_{1-4}$-Alkoxy, -CN, $C_{2-5}$-Alkoxycarbonyl, Phenyl, Chlorphenyl, $C_{7-10}$-Alkylphenyl oder $C_{7-10}$-Alkoxyphenyl substituiertes $C_{1-8}$-Alkyl, unsubstituiertes oder durch -Cl, $C_{1-4}$-Alkyl, $C_{1-4}$-Alkoxy oder $C_{1-4}$-Alkylthio substituiertes Phenyl, $C_{2-8}$-Alkoxycarbonyl oder -CN bedeutet.

3. Verfahren nach Anspruch 1, worin der Sulfonsäureester eine Verbindung der Formel II

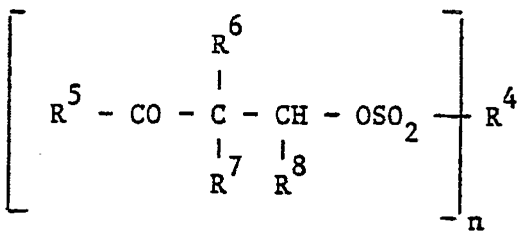

(II)

ist, worin
n 1 oder 2 darstellt,
$R^4$ bei n = 1 $C_{1-18}$-Alkyl, unsubstituiertes oder durch Halogen, $C_{1-12}$-Alkyl, $C_{1-4}$-Alkoxy, $C_{1-4}$-Alkyl-CONH-, Phenyl-CONH-, $NO_2$ oder Benzoyl substituiertes Phenyl, unsubstituiertes oder durch Halogen, $C_{1-12}$-Alkyl oder $C_{1-4}$-Alkoxy substituiertes Naphthyl, $C_{5-6}$-Cycloalkyl, $C_{7-9}$-Aralkyl, Campheryl, $-CF_3$, $-CCl_3$, -F oder $-NH_2$ und bei n = 2 eine-$(CH_2)_m$-Gruppe mit m = 2-8, unsubstituiertes oder durch $C_{1-15}$-Alkyl substituiertes Phenylen oder Naphthylen bedeutet,
$R^5$ unsubstituiertes oder durch 1, 2 oder 3 von -Cl, -Br, $C_{1-12}$-Alkyl, Phenyl, $C_{1-8}$-Alkoxy, Phenyloxy, Benzyloxy, $C_{1-8}$-Alkylthio, Phenylthio, $-SCH_2CH_2OH$, $C_{1-4}$-Alkyl-CONH-, Benzoylamino, Dimethylamino oder Benzoyl substituiertes Phenyl oder Naphthyl, Anthryl oder Phenylanthryl darstellt.
$R^6$ Wasserstoff, -OH, $C_{1-4}$-Alkoxy, $-OSi(CH_3)_3$, $-OCOCH_3$ oder unsubstituiertes oder durch Phenyl substituiertes $C_{1-8}$-Alkyl ist,
$R^7$ Wasserstoff, unsubstituiertes oder durch Phenyl substituiertes $C_{1-8}$-Alkyl, -CN, Benzoyl, $C_{1-4}$-Alkylcarbonyl, $C_{2-5}$-Alkoxycarbonyl oder Phenyl bedeutet,
$R^8$ Wasserstoff, unsubstituiertes oder durch -OH, -Cl oder Phenyl substituiertes $C_{1-8}$-Alkyl, unsubstituiertes oder durch -OH, -Cl, $C_{1-4}$-Alkyl oder $C_{1-4}$-Alkoxy substituiertes Phenyl, $C_{2-6}$-Alkenyl, $C_{8-9}$-Phenylalkenyl, Furyl, Thienyl, $-CCl_3$ oder gesättigtes oder ungesättigtes $C_{5-6}$-Cycloalkyl darstellt, und worin
$R^5$ und $R^7$ oder $R^6$ und $R^7$ zusammen mit der Kohlenstoffstruktur, an welche sie gebunden sind, einen 5- oder 6-gliedrigen Ring mit 1-5 $-CH_2-$, $-CH(CH_3)_2-$, -O-, -S-, -SO-, $-SO_2-$, -CO-, -N(CO-$C_{1-4}$-Alkyl)- oder $-N(COC_6H_5)$-Gruppen bilden.

**4.** Verfahren nach Anspruch 1, worin der Sulfonsäureester eine Verbindung der Formel VI

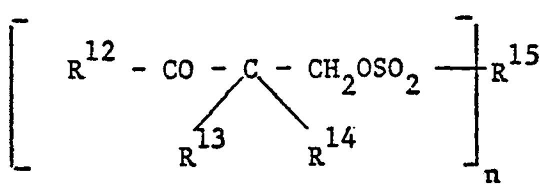

(IV),

ist, worin
n 1 oder 2 ist,
$R^{12}$ und $R^{13}$ unabhängig voneinander unsubstituiertes oder durch $C_{1-4}$-Alkyl, $C_{1-4}$-Alkoxy, Halogen, Phenyl oder Dialkylamino mit je 1-4 C-Atomen substituiertes Phenyl bedeuten, wobei die Dialkylaminogruppen durch eine Hydroxylgruppe substituiert sein können,
$R^{14}$ unsubstituiertes oder substituiertes $C_{5-18}$-Alkyl, $C_{2-18}$-Alkenyl, $C_{5-8}$-Cycloalkyl oder Cycloalkenyl, unsubstituiertes oder substituiertes $C_{6-20}$-Aryl, Furyl oder eine Gruppe -(E)CH-OZ bedeutet, worin E $-CH_3$ und Z $C_{2-4}$-Alkyl bedeuten oder E und Z zusammen eine unsubstituierte oder durch eine $C_{1-4}$-Alkoxygruppe substituierte 1,3- oder 1,4-Alkylengruppe mit 3 oder 4 C-Atomen darstellen,
$R^{15}$ unsubstituiertes oder substituiertes $C_{1-20}$-Alkyl, $C_{4-20}$-Alkenyl, $C_{5-8}$-Cycloalkyl, $C_{5-8}$-Cycloalkenyl, Phenyl, Tolyl, Naphthyl, Alkaryl mit 4-16 C-Atomen in der Alkylgruppe, Furfuryl, $C_{6-10}$-Arylen oder $C_{1-6}$-Alkylen darstellt.

**5.** Verfahren nach Anspruch 1, worin das N-Sulfonyloxyimid eine Verbindung der Formel V

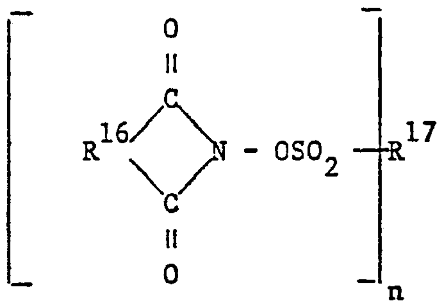

(V)

ist, worin
n 1 oder 2 ist,
$R^{16}$ Arylen, substituiertes Arylen, Alkylen, substituiertes Alkylen, Alkenylen, substituiertes Alkenylen, geradkettiges, verzweigtes oder cyclisches $C_{2-6}$-Alkylen, das durch Phenyl, Naphthyl oder $C_{1-4}$-Alkyl substituiert sein kann, unsubstituiertes oder durch Phenyl oder $C_{1-2}$-Alkyl substituiertes $C_{2-4}$-Alkenylen bedeutet, und
$R^{17}$ bei n = 1, geradkettiges oder verzweigtes, unsubstituiertes oder durch Halogen oder $C_{1-4}$-Alkoxy substituiertes $C_{1-18}$-Alkyl, unsubstituiertes oder durch $C_{1-15}$-Alkyl, $C_{1-4}$-Alkyl-CONH-,Phenyl-CONH- oder $-NO_2$ substituiertes $C_{6-12}$-Aryl, $C_{5-6}$-Cycloalkyl, Campheryl, $-CF_3$, $-CCl_3$, $-CH_2Cl$, -F oder $-NH_2$ oder bei n = 2 $C_{2-6}$-Alkylen, Phenylen oder Naphthylen darstellt, mit der Massgabe, dass mindestens eines von $R^{16}$ und $R^{17}$ eine aromatische Gruppe ist oder eine aromatische Gruppe enthält.

**6.** Verfahren nach einem der vorhergehenden Ansprüche, worin das filmbildende organische Material (A) eine phenolische Hydroxylgruppe oder eine Carbonsäure-, Sulfonsäure-, Phosphonsäure- oder Phosphorsäuregruppe enthält.

**7.** Verfahren nach Anspruch 6, worin das filmbildende organische Material (A) ein Novolak-Harz oder ein Homopolymer oder Copolymer einer ethylenisch ungesättigten Carbonsäure oder eines Carbonsäureanhydrids ist.

**8.** Verfahren nach einem der vorhergehenden Ansprüche, worin das Stoffgemisch 0,05 bis 0,8 Gewichtsteile einer Sulfonsäure-freisetzenden Substanz (B) pro Gewichtsteil des filmbildenden organischen Materials (A) enthält.

**9.** Photoempfindliches Stoffgemisch, geeignet für die Durchführung des Verfahrens nach einem der vorhergehenden Ansprüche enthaltend
(A) ein filmbildendes organisches Material und
(B) einen Sulfonsäureester eines aromatischen Alkohols mit einer Carbonylgruppe oder ein aromatisches N-Sulfonyloxyimid, die unter aktinischer Bestrahlung mit 200-600 nm Wellenlänge eine Sulfonsäure freigeben, enthält,
wobei das Stoffgemisch im wesentlichen frei von ethylenisch ungesättigtem Material ist, das in Gegenwart freier Radikale polymerisiert, und im wesentlichen frei von Material ist, das in Gegenwart von Sulfonsäuren polymerisiert.

**10.** Stoffgemisch nach Anspruch 9, worin (B) eine Sulfonsäurefreigebende Verbindung gemäss den Ansprüchen 2 bis 5 ist.

**11.** Stoffgemisch nach Anspruch 9 oder 10, worin (A) ein filmbildendes Material gemäss dem Anspruch 6 oder 7 ist.

**12.** Stoffgemisch nach Anspruch 9, 10 oder 11, enthaltend 0,05-0,8 Gewichtsteile (B) pro Gewichsteil (A).

## Claims

**1.** A process for the production of an image comprising
(i) exposing to actinic light in a predetermined pattern a composition supported on a substrate, which composition comprises

(A) a film-forming organic material and

(B) a sulphonic acid ester of an aromatic alcohol having a carbonyl group or an aromatic N-sulphonyloxyimide which releases a sulphonic acid on exposure to actinic radiation having a wavelength of 200-600 nm, thereby rendering the composition more soluble in an aqueous base developer in the exposed areas than in the unexposed areas, and

(ii) removing the composition in the exposed areas by treatment with the aqueous base developer.

2. A process according to claim 1, in which the sulphonic acid ester is a compound of formula I or III

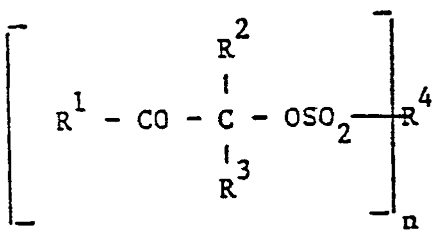

(I)

or

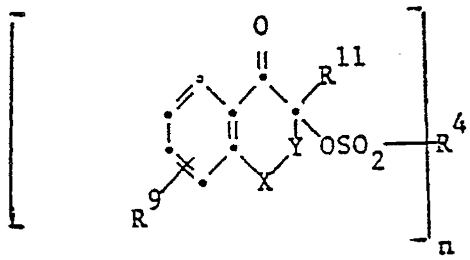

(III)

in which

n is 1 or 2,

$R^1$ is phenyl or naphthyl which is unsubstituted or substituted by 1, 2 or 3 of -Cl, -Br, -CN, $-NO_2$, $C_1$-$C_{12}$alkyl, $C_1$-$C_4$alkoxy, phenyloxy, tolyloxy, phenylthio, tolylthio, $C_1$-$C_8$alkylthio, $-SCH_2OH$, $C_1$-$C_4$alkylsulphonyl, phenylsulphonyl, $C_2$-$C_4$alkoxycarbonyl, $C_1$-$C_4$alkylamino, $C_2$-$C_4$dialkylamino, phenyl-CONH-, $C_1$-$C_4$alkyl-CONH- or benzoyl, or $R^1$ is anthryl, phenanthryl, thienyl, pyridyl, furyl, indolyl or tetrahydronaphthyl, $R^2$ and $R^3$ are each independently of one another hydrogen, or $C_1$-$C_8$alkyl which is unsubstituted or substituted by -OH, -Cl, $C_1$-$C_4$alkoxy, -CN, $C_2$-$C_5$alkoxycarbonyl, phenyl, chlorophenyl, $C_7$-$C_{10}$alkylphenyl or $C_7$-$C_{10}$alkoxyphenyl, or they are benzoyl, in addition $R^3$ may be phenyl which is unsubstituted or substituted by -Cl, $C_1$-$C_4$alkyl, $C_1$-$C_4$alkoxy or $C_1$-$C_4$alkylthio, or it is $C_2$-$C_8$alkoxycarbonyl, -CN, $C_1$-$C_4$alkyl-NH-CO-, phenyl-NH-CO- or $-CONH_2$, or $R^2$ and $R^3$ together with the carbon atom to which they are bonded form a $C_4$-$C_6$cycloalkyl ring,

when n = 1, $R^4$ is $C_1$-$C_{18}$alkyl, phenyl which is unsubstituted or substituted by halogen, $C_1$-$C_{12}$alkyl, $C_1$-$C_4$alkoxy, $C_1$-$C_4$alkyl-CONH-, phenyl-CONH-, $-NO_2$ or benzoyl, or it is naphthyl which is unsubstituted or substituted by halogen, $C_1$-$C_{12}$alkyl or $C_1$-$C_4$alkoxy, or it is $C_5$-$C_6$cycloalkyl, $C_7$-$C_9$aralkyl, campheryl, $-CF_3$, $-CCl_3$, -F, or $-NH_2$, and, when n = 2, $R^4$ is a $-(CH_2)_m$ group, where m is 2 to 8, or phenylene or naphthylene each unsubstituted or substituted by $C_1$-$C_{15}$alkyl,

$R^8$ is a hydrogen atom or 1, 2 or 3 -Cl, -Br, $-NO_2$, $C_1$-$C_{12}$alkyl, $C_1$-$C_4$alkoxy, phenoxy, phenylthio, $C_1$-$C_8$alkylthio or $-SCH_2CH_2OH$ substituents,

X is -O-, -S-, $SO_2$-, $-C(CH_3)_2$- or $NCOR^{10}$, in which $R^{10}$ is $C_1$-$C_4$alkyl or phenyl,

Y is a direct bond or $-CH_2$-, and

$R^{11}$ is a hydrogen atom; $C_1$-$C_8$alkyl which is unsubstituted or substituted by -OH, -Cl, $C_1$-$C_4$alkoxy, -CN, $C_2$-$C_5$alkoxycarbonyl, phenyl, chlorophenyl, $C_7$-$C_{10}$alkylphenyl, or $C_7$-$C_{10}$alkoxyphenyl; phenyl which is unsubstituted or substituted by -Cl, $C_1$-$C_4$alkyl, $C_1$-$C_4$alkoxy or $C_1$-$C_4$alkylthio; $C_2$-$C_8$alkoxycarbonyl; or -CN.

3. A process according to claim 1, in which the sulphonic acid ester is a compound of formula II

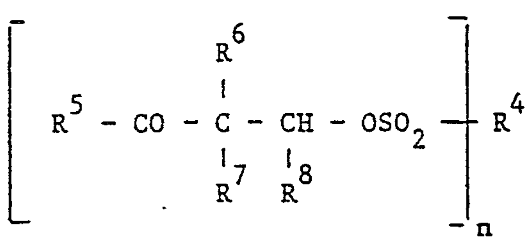

II

in which

n is 1 or 2,
when n = 1, $R^4$ is $C_1$-$C_{18}$alkyl, phenyl which is unsubstituted or substituted by halogen, $C_1$-$C_{12}$alkyl, $C_1$-$C_4$alkoxy, $C_1$-$C_4$alkyl-CONH-, phenyl-CONH, $-NO_2$ or benzoyl, or it is naphthyl which is unsubstituted or substituted by halogen, $C_1$-$C_{12}$alkyl or $C_1$-$C_4$alkoxy, or it is $C_5$-$C_6$cycloalkyl, $C_7$-$C_9$aralkyl, campheryl, $-CF_3$, $-CCl_3$, -F, or $-NH_2$, and, when n = 2, $R^4$ is a $-(CH_2)_m$ group, where m is 2 to 8, or phenylene or naphthylene each unsubstituted or substituted by $C_1$-$C_{15}$alkyl,
$R^5$ is phenyl or naphthyl which are each unsubstituted or substituted by 1, 2 or 3 of -Cl, -Br, $C_1$-$C_{12}$alkyl, phenyl, $C_1$-$C_8$alkoxy, phenyloxy, benzyloxy, $C_1$-$C_8$alkylthio, phenylthio, $-SCH_2CH_2OH$, $C_1$-$C_4$alkyl-CONH-,benzoylamino, dimethylamino or benzoyl, or $R^5$ is naphthyl, anthryl or phenanthryl,
$R^6$ is hydrogen, -OH, $C_1$-$C_4$alkoxy, $-OSi(CH_3)_3$, $-OCOCH_3$, or $C_1$-$C_8$alkyl which is unsubstituted or substituted by phenyl,
$R^7$ is hydrogen, or $C_1$-$C_8$alkyl which is unsubstituted or substituted by phenyl, or it is -CN, benzoyl, $C_1$-$C_4$alkylcarbonyl, $C_2$-$C_5$alkoxycarbonyl or phenyl,
$R^8$ is hydrogen, $C_1$-$C_8$alkyl which is unsubstituted or substituted by -OH, -Cl or phenyl, or it is phenyl which is unsubstituted or substituted by -OH, -Cl, $C_1$-$C_4$alkyl or $C_1$-$C_4$alkoxy, or it is $C_2$-$C_6$alkenyl, $C_8$-$C_9$phenylalkenyl, furyl, thienyl, $-CCl_3$ or saturated or unsaturated $C_5$-$C_6$cycloalkyl, and in which
$R^5$ and $R^7$ or $R^6$ and $R^7$, together with the carbon structure to which they are bonded, form a 5- or 6-membered ring having 1 to 5 $-CH_2-$, $-CH(CH_3)_2-$, -O-, -S-, -SO-, $-SO_2-$, -CO-, -N(CO-$C_1$-$C_4$alkyl)- or -N-$(COC_6H_5)$- groups.

**4.** A process according to claim 1, in which the sulphonic acid ester is a compound of formula IV

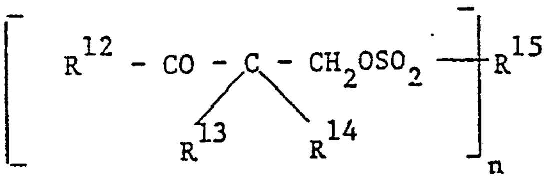

(IV)

in which
n is 1 or 2,
$R^{12}$ and $R^{13}$ are each independently of one another phenyl which is unsubstituted or substituted by $C_1$-$C_4$alkyl, $C_1$-$C_4$alkoxy, halogen, phenyl, or dialkylamino each having 1-4 carbon atoms and where the dialkyamino groups may be substituted by a hydroxyl group,
$R^{14}$ is unsubstituted or substituted $C_5$-$C_{18}$alkyl, $C_2$-$C_{18}$alkenyl, $C_5$-$C_8$cycloalkyl or cycloalkenyl, unsubstituted or substituted $C_6$-$C_{20}$aryl, furyl, or a group -(E)CH-OZ in which E is $-CH_3$ and Z is $C_2$-$C_4$alkyl or E and Z together are a 1,3- or 1,4-alkylene group having 3 to 4 carbon atoms which is unsubstituted or substituted by a $C_1$-$C_4$alkoxy group,
$R^{15}$ is unsubstituted or substituted $C_1$-$C_{20}$alkyl, $C_4$-$C_{20}$alkenyl, $C_5$-$C_8$cycloalkyl, $C_5$-$C_8$cycloalkenyl, phenyl, tolyl, naphthyl, alkaryl having 4-16 carbon atoms in the alkyl group, furfuryl, $C_6$-$C_{10}$arylene or $C_1$-$C_6$alkylene.

**5.** A process according to claim 1, in which the N-sulphonyloxyimide is a compound of formula V

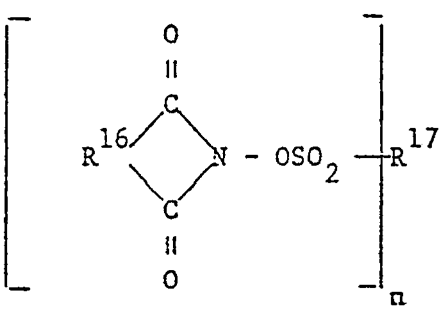

(V)

in which
n is 1 or 2,
$R^{16}$ is arylene, substituted arylene, alkylene, substituted alkylene, alkenylene, substituted alkenylene,

straight-chain, branched or cyclic $C_2$-$C_6$alkylene which is unsubstituted or substituted by phenyl, naphthyl or $C_1$-$C_4$alkyl, or it is $C_2$-$C_4$alkenylene which is unsubstituted or substituted by phenyl or $C_1$-$C_2$alkyl, and
when n = 1, $R^{17}$ is straight-chain or branched $C_1$-$C_{18}$alkyl which is unsubstituted or substituted by halogen or $C_1$-$C_4$alkoxy, $C_6$-$C_{12}$aryl which is unsubstituted or substituted by $C_1$-$C_{15}$alkyl, $C_1$-$C_4$alkyl-CONH-, phenyl-CONH- or $-NO_2$, $C_5$-$C_6$cycloalkyl, campheryl, $-CF_3$, $-CCl_3$, $-CH_2Cl$, -F, or $-NH_2$, or where n = 2, $R^{17}$ is $C_2$-$C_6$alkylene, phenylene or naphthylene, with the proviso that at least one of $R^{16}$ and $R^{17}$ is an aromatic group or contains an aromatic group.

**6.** A process according to one of the preceding claims, in which the film-forming organic material (A) contains a phenolic hydroxyl group or a carboxylic acid group, a sulphonic acid group, a phosphonic acid group or a phosphoric acid group.

**7.** A process according to claim 6, in which the film-forming organic material (A) is a novolak resin or a homopolymer or copolymer of an ethylenically unsaturated carboxylic acid or carboxylic acid anhydride.

**8.** A process according to one of the preceding claims, in which the composition contains from 0.05 to 0.8 part by weight of a sulphonic acid-liberating substance (B) per part by weight of the film-forming organic material (A).

**9.** A photosensitive composition suitable for carrying out the process according to one of the preceding claims which comprises
(A) a film-forming organic material and
(B) a sulphonic acid ester of an aromatic alcohol having a carbonyl group or an aromatic N-sulphonyloxyimide which release a sulphonic acid on exposure to actinic radiation having a wavelength of 200-600 nm,
the composition being substantially free from ethylenically unsaturated material which polymerises in the presence of free radicals and being substantially free from material which polymerises in the presence of sulphonic acids.

**10.** A composition according to claim 9, in which (B) is a sulphonic acid-liberating compound according to claims 2 to 5.

**11.** A composition according to claim 9 or 10, in which (A) is a film-forming material according to claim 6 or 7.

**12.** A composition according to claim 9, 10 or 11, containing 0.05-0.8 part by weight of (B) per part by weight of (A).

## Revendications

**1.** Procédé pour créer des images caractérisé en ce que :
(I) on irradie par un rayonnement actinique, conformément à un modèle donné, un mélange qui se trouve sur une matière support et qui contient :
(A) une matière organique feuillogène et
(B) un ester sulfonique d'un alcool aromatique renfermant un radical carbonyle, ou un N-sulfonyloxy-imide aromatique, qui libèrent un acide sulfonique sous l'action d'un rayonnement actinique d'une longueur d'onde comprise entre 200 et 600 nm,
le mélange devenant alors plus soluble dans des développateurs basiques aqueux aux endroits touchés par le rayonnement qu'aux endroits non touchés par le rayonnement et,
(II) on élimine le mélange aux endroits touchés par le rayonnement en effectuant un traitement par un développateur basique aqueux.

**2.** Procédé selon la revendication 1 caractérisé en ce que l'ester d'acide sulfonique est un composé répondant à l'une des formules I et III :

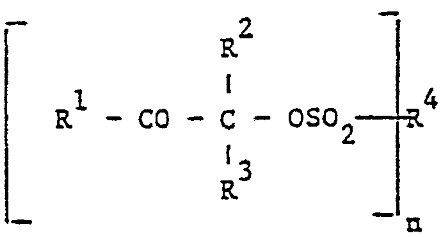

(I)

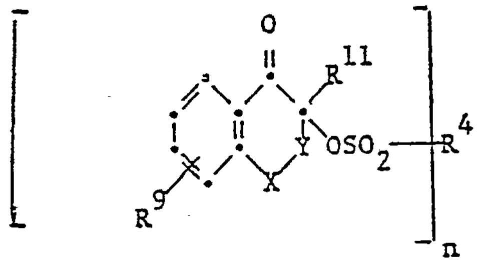

(III)

dans lesquelles

n est égal à 1 ou à 2,

$R^1$ représente un radical phényle ou naphtyle non substitué ou porteur d'un, de deux ou de trois substituants pris dans l'ensemble constitué par -Cl, -Br, -CN, $-NO_2$, les alkyles en $C_1$-$C_{12}$, les alcoxy en $C_1$-$C_4$, le phényloxy, les tolyloxy, le phénylthio, les tolylthio, les alkylthio en $C_1$-$C_8$, $-SCH_2OH$, les alkylsulfonyles en $C_1$-$C_4$, le phénylsulfonyle, les alcoxycarbonyles en $C_2$-$C_4$, les alkylamino en $C_1$-$C_4$, les dialkylamino en $C_2$-$C_4$, le phénylcarbonylamino, les radicaux alkyl-CONH- à alkyle en $C_1$-$C_4$ et le benzoyle, ou représente un radical anthryle, phénanthryle, thiényle, pyridyle, furyle, indolyle ou tétrahydronaphtyle,

$R^2$ et $R^3$ représentent chacun, indépendamment l'un de l'autre, l'hydrogène un alkyle en $C_1$-$C_8$ non substitué ou porteur d'un -OH, d'un -Cl, d'un alcoxy en $C_1$-$C_4$, d'un -CN, d'un alcoxycarbonyle en $C_2$-$C_5$, d'un phényle, d'un chlorophényle, d'un alkylphényle en $C_7$-$C_{10}$ ou d'un alcoxyphényle en $C_7$-$C_{10}$, ou un benzoyle, le symbole $R^3$ pouvant en outre représenter un phényle non substitué ou porteur d'un -Cl, d'un alkyle en $C_1$-$C_4$, d'un alcoxy en $C_1$-$C_4$ ou d'un alkylthio en $C_1$-$C_4$, un alcoxycarbonyle en $C_2$-$C_8$, un -CN, un alkylaminocarbonyle à alkyle en $C_1$-$C_4$, un phénylaminocarbonyle ou un radical $-CONH_2$, ou

$R^2$ et $R^3$ forment ensemble, et avec l'atome de carbone auquel ils sont liés, un cycle cycloalkyle en $C_4$-$C_6$,

$R^4$ représente :

- lorsque n est égal à 1, un alkyle en $C_1$-$C_{18}$, un phényle non substitué ou porteur d'un halogène, d'un alkyle en $C_1$-$C_{12}$, d'un alcoxy en $C_1$-$C_4$, d'un alkylcarbonylamino à alkyle en $C_1$-$C_4$, d'un phénylcarbonylamino, d'un $-NO_2$ ou d'un benzoyle, un naphtyle non substitué ou porteur d'un halogène, d'un alkyle en $C_1$-$C_{12}$ ou d'un alcoxy en $C_1$-$C_4$, un cycloalkyle en $C_5$ ou $C_6$, un aralkyle en $C_7$-$C_9$, un camphéryle, un $-CF_3$, un $-CCl_3$, un -F ou un $-NH_2$, et
- lorsque n est égal à 2, un radical $-(CH_2)_m-$ dans lequel m désigne un nombre de 2 à 8, ou un radical phénylène ou naphtylène non substitué ou porteur d'un alkyle en $C_1$-$C_{15}$,

$R^9$ représente un atome d'hydrogène ou 1, 2 ou 3 substituants pris dans l'ensemble constitué par -Cl, -Br, $-NO_2$, les alkyles en $C_1$-$C_{12}$, les alcoxy en $C_1$-$C_4$, le phénoxy, le phénylthio, les alkylthio en $C_1$-$C_8$ et le radical $-SCH_2CH_2OH$,

X représente -O-, -S-, $-SO_2-$, $-C(CH_3)_2-$ ou un radical $-NCOR^{10}$ dans lequel $R^{10}$ représente un alkyle en $C_1$-$C_4$ ou un phényle,

Y représente une liaison directe ou un radical $-CH_2-$ et

$R^{11}$ représente un atome d'hydrogène, un alkyle en $C_1$-$C_8$ non substitué ou porteur d'un -OH, -Cl, d'un alcoxy en $C_1$-$C_4$,d'un -CN, d'un alcoxycarbonyle en $C_2$-$C_5$, d'un phényle, d'un chlorophényle, d'un alkylphényle en $C_7$-$C_{10}$ ou d'un alcoxyphényle en $C_7$-$C_{10}$, un phényle non substitué ou porteur d'un -Cl, d'un alkyle en $C_1$-$C_4$, d'un alcoxy en $C_1$-$C_4$ ou d'un alkylthio en $C_1$-$C_4$, un alcoxycarbonyle en $C_2$-$C_8$ ou un -CN.

**3.** Procédé selon la revendication 1 dans lequel l'ester d'acide sulfonique est un composé répondant à la formule II :

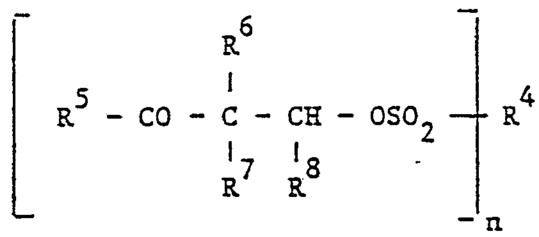

(II)

dans laquelle

n est égal à 1 ou à 2,

$R^4$ représente :

- dans le cas où n est égal à 1, un alkyle en $C_1$-$C_8$, un phényle non substitué ou porteur d'un halogène, d'un alkyle en $C_1$-$C_{12}$, d'un alcoxy en $C_1$-$C_4$, d'un alkylcarbonylamino à alkyle en $C_1$-$C_4$, d'un phénylcarbonylamino, d'un $NO_2$ ou d'un benzoyle, un naphtyle non substitué ou porteur d'un halogène, d'un alkyle en $C_1$-$C_{12}$ ou d'un alcoxy en $C_1$-$C_4$, un cycloalkyle en $C_5$ ou $C_6$, un aralkyle en $C_7$-$C_9$, un camphéryle, un $-CF_3$, un $-CCl_3$, un -F ou un $-NH_2$, et
- dans le cas où n est égal à 2, un radical $-(CH_2)_m-$ dont l'indice m désigne un nombre de 2 à 8, ou un radical phénylène ou naphtylène non substitué ou porteur d'un alkyle en $C_1$-$C_{15}$,

$R^5$ représente un radical phényle ou naphtyle non substitué ou porteur de 1, 2 ou 3 substituants pris dans l'ènsemble constitué par -Cl, -Br, les alkyles en $C_1$-$C_{12}$,le phényle, les alcoxy en $C_1$-$C_8$, le phényloxy, le benzyloxy, les alkylthio en $C_1$-$C_8$, le phénylthio, le radical $-SCH_2CH_2OH$, les alkylcarbonylamino à alkyle en $C_1$-$C_4$, le benzoylamino, le diméthylamino et le benzoyle, un anthryle ou un phénylanthryle,

$R^6$ représente l'hydrogène, -OH, un alcoxy en $C_1$-$C_4$, $-OSi(CH_3)_3$, $-OCOCH_3$ ou un alkyle en $C_1$-$C_8$ non substitué ou porteur d'un phényle,

$R^7$ représente l'hydrogène, un alkyle en $C_1$-$C_8$ non substitué ou porteur d'un phényle, un -CN, un benzoyle, un alkylcarbonyle à alkyle en $C_1$-$C_4$, un alcoxycarbonyle en $C_2$-$C_5$ ou un phényle,

$R^8$ représente l'hydrogène, un alkyle en $C_1$-$C_8$ non substitué ou porteur d'un -OH, d'un -Cl ou d'un phényle, un phényle non substitué ou porteur d'un -OH, d'un -Cl, d'un alkyle en $C_1$-$C_4$ ou d'un alcoxy en $C_1$-$C_4$, un alcényle en $C_2$-$C_6$, ou un phénylalcényle en $C_8$ ou $C_9$, un furyle, un thiényle, un $-CCl_3$ ou un cycloalkyle en 5 ou $C_6$ saturé ou insaturé, et

$R^5$ et $R^7$ ou $R^6$ et $R^7$ forment ensemble, et avec la structure carbonée à laquelle ils sont liés, un cycle à 5 ou 6 maillons renfermant de 1 à 5 groupes $-CH_2-$, $-C(CH_3)_2-$, -O-, -S-, -SO-, $-SO_2-$, -CO-, $-N(CO-C_1-C_4\text{-alkyl})-$ ou $-N(COC_6H_5)-$.

4. Procédé selon la revendication 1 dans lequel l'ester d'acide sulfonique est un composé répondant à la formule IV :

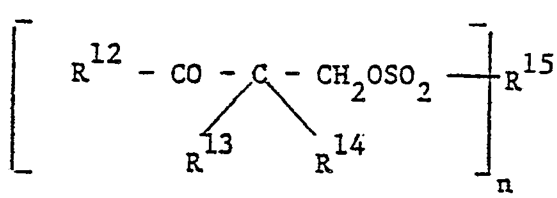

(IV)

dans laquelle

n est égal à 1 ou à 2,

$R^{12}$ et $R^{13}$ représentent chacun, indépendamment l'un de l'autre, un phényle non substitué ou porteur d'un alkyle en $C_1$-$C_4$,d'un alcoxy en $C_1$-$C_4$, d'un halogène, d'un phényle ou d'un dialkylamino dont chacun des alkyles contient de 1 à 4 atomes de carbone, les radicaux dialkylamino pouvant porter un radical hydroxy,

$R^{14}$ représente un alkyle en $C_5$-$C_{18}$ substitué ou non, un alcényle en $C_2$-$C_{18}$, un cycloalkyle en $C_5$-$C_8$ ou un cycloalcényle, un aryle en $C_6$-$C_{20}$ substitué ou non, un furyle ou un radical -(E)CH-OZ dans lequel E représente $CH_3$ et Z un alkyle en $C_2$-$C_4$, ou E et Z forment ensemble un alkylène -1,3 ou -1,4 à 3 ou 4 atomes de carbone, non substitué ou porteur d'un alcoxy en $C_1$-$C_4$, ou

$R^{15}$ représente un alkyle en $C_1$-$C_{20}$ substitué ou non, un alcényle en $C_4$-$C_{20}$, un cycloalkyle en $C_5$-$C_8$, un cycloalcényle en $C_5$-$C_8$, un phényle, un tolyle, un naphtyle, un alkylaryle dont l'alkyle contient de 4 à 16 atomes de carbone, un furfuryle, un arylène en $C_6$-$C_{10}$ ou un alkylène en $C_1$-$C_6$.

**5.** Procédé selon la revendication 1 dans lequel le N-sulfonyloxy-imide est un composé répondant à la formule V :

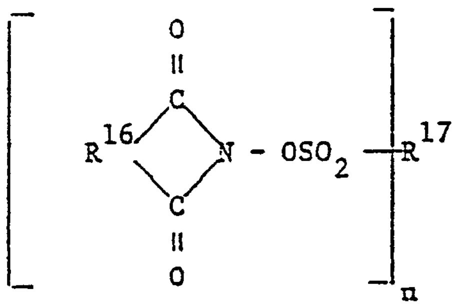

(V)

dans laquelle

n est égal à 1 ou à 2,

$R^{16}$ représente un arylène, un arylène substitué, un alkylène, un alkylène substitué, un alcénylène, un alcénylène substitué, un alkylène en $C_2$-$C_6$ linéaire,ramifié ou cyclique et éventuellement porteur d'un phényle, d'un naphtyle ou d'un alkyle en $C_1$-$C_4$, ou un alcénylène en $C_2$-$C_4$ non substitué ou porteur d'un phényle ou d'un alkyle en $C_1$ ou $C_2$, et

$R^{17}$ représente :

- lorsque n est égal à 1, un alkyle en $C_1$-$C_{18}$ linéaire ou ramifié, non substitué ou porteur d'un halogène ou d'un alcoxy en $C_1$-$C_4$, un aryle en $C_6$-$C_{12}$ non substitué ou porteur d'un alkyle en $C_1$-$C_{15}$, d'un alkylcarbonylamino à alkyle en $C_1$-$C_4$, d'un phénylcarbonylamino ou d'un $-NO_2$, un cycloalkyle en $C_5$ ou $C_6$, un camphéryle, un $-CF_3$, un $-CCl_3$, un $-CH_2Cl$, un -F ou un $-NH_2$, ou
- lorsque n est égal à 2, un alkylène en $C_2$-$C_6$, un phénylène ou un naphtylène,

avec la condition qu'au moins un des radicaux $R^{16}$ et $R^{17}$ soit un radical aromatique ou contienne un radical aromatique.

**6.** Procédé selon l'une quelconque des revendications précédentes dans lequel la matière organique feuillogène (A) contient un radical hydroxy phénolique ou un radical d'acide carboxylique, d'acide sulfonique, d'acide phosphonique ou d'acide phosphorique.

**7.** Procédé selon la revendication 6, dans lequel la matière organique feuillogène (A) est une résine novolaque ou un homopolymère ou copolymère d'un acide carboxylique éthylénique ou d'un anhydride d'acide carboxylique éthylénique.

**8.** Procédé selon l'une quelconque des revendications précédentes dans lequel le mélange contient de 0,05 à 0,8 partie en poids d'une substance (B) libérant un acide sulfonique par partie en poids de la matière organique feuillogène (A).

**9.** Mélange photosensible qui convient pour l'exécution du procédé selon l'une quelconque des revendications précédentes et qui contient :

(A) une matière organique feuillogène et

(B) un ester sulfonique d'un alcool aromatique renfermant un radical carbonyle, ou un N-sulfonyloxy-imide aromatique, qui libèrent un acide sulfonique sous l'action d'un rayonnement actinique d'une longueur d'onde comprise entre 200 et 600 nm,

le mélange étant pratiquement dépourvu de matières à insaturation éthylénique qui se polymérisent en présence de radicaux libres, et pratiquement dépourvu de matières qui se polymérisent en présence d'acides sulfoniques.

**10.** Mélange selon la revendication 9 dans lequel il y a (B) un composé libérant un acide sulfonique selon l'une quelconque des revendications 2 à 5.

**11.** Mélange selon l'une des revendications 9 et 10 dans lequel il y a (A) une matière feuillogène selon l'une des revendications 6 et 7.

**12.** Mélange selon l'une quelconque des revendications 9, 10 et 11 qui contient de 0,05 à 0,8 parties en poids de (B) par partie en poids de (A).